# EUROPEAN PATENT APPLICATION

(11) **EP 4 693 378 A1**
(43) Date of publication of application: **11.02.2026**
(21) Application number: 24207419.3
(22) Date of filing: 18.10.2024
(51) Int. Cl.: H01L 21/48, H01L 23/538

(54) **FAN-OUT PACKAGE INCLUDING BRIDGE STRUCTURE AND METHOD OF MANUFACTURING THE SAME**

(30) Priority: 09.08.2024 KR 20240106998
(71) Applicant: Silicon Box Pte. Ltd., Singapore 529580 (SG)
(72) Inventor: HAN, Byung Joon, 06067 SEOUL (KR); AHN, Byung Hoon, 16941 GYEONGGI-DO (KR)
(74) Representative: Cabinet Beaumont

(57) **Abstract**

Disclosed is a fan-out package in which two or more dies are integrated in a fan-out packaging process, wherein the fan-out package includes a bridge structure including a bridge substrate formed on one side of the fan-out package, a redistribution layer formed on the bridge substrate, the redistribution layer including at least one trace, the redistribution layer being configured to electrically connect the dies to each other, and a passive element formed in the redistribution layer by patterning. The routing density of the trace is relieved, and electrical performance is improved by the provision of the passive element.

## Description

### BACKGROUND OF THE INVENTION

### 1. Field of the invention

The present invention relates to a fan-out package and a method of manufacturing the same, and more particularly to a fan-out package including a bridge structure that improves the degree of freedom of trace design and improves electrical performance and a method of manufacturing the same.

### 2. Description of the Related Art

In general, a semiconductor packaging process includes wafer dicing, die attachment, die interconnection, molding, and packaging test steps.

In a conventional semiconductor packaging process, a wafer is cut and a packaging process is carried out, whereas in recent years, a "wafer level packaging" process is carried out while a die is kept in a wafer state, which has the advantage of reducing the cost of package production compared to the conventional process by carrying out a packaging process and a test at one time in the wafer state and then cutting a chip.

As semiconductor devices become highly integrated, high-performance, and miniaturized, various packaging technologies are evolving based on such a wafer level packaging method, and especially fan-in wafer level packaging and fan-out wafer level packaging are being actively researched.

In addition, due to a rapid increase in data throughput in recent years, the concept of a chiplet, which is not a conventional system on chip (SoC), is being introduced, wherein different chips (modules) are manufactured on different wafers and integrated into a chip. That is, the concept of a chiplet is to interconnect chips manufactured on different wafers to form an SoC having a single function.

In addition, in such a wafer level packaging method, heterogeneous integration techniques, which package heterogeneous chips having different functions, such as 2.5D packaging and 3D packaging, on a single substrate in 2D packaging, are being actively researched to further increase the degree of integration.

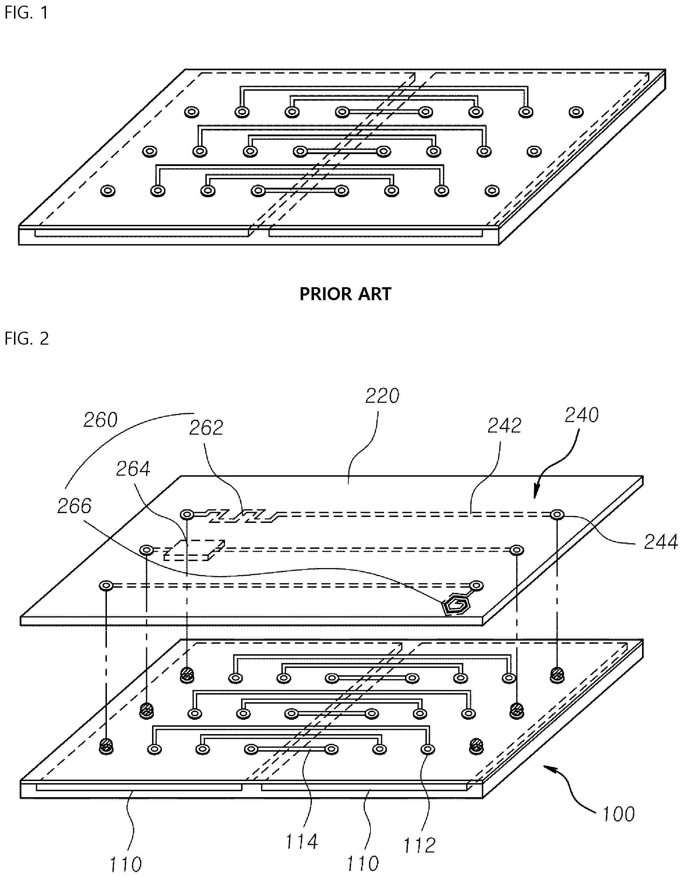

Such a chiplet packaging concept has been widely studied due to the recent surge in the semiconductor market, which has led to an increase in data throughput and processing speed, but has been limited by space limitations in trace design, as shown in FIG. 1.

That is, not only is it difficult to interconnect chips due to the increased routing density of traces, but also the interference between the traces is high, which is likely to cause short circuits and signal transmission errors, and the I/O count is limited.

Meanwhile, the design of fan-out packages requires a large number and variety of passive elements to improve electrical performance, but it is not easy to dispose passive elements due to space limitations in recent packaging processes with higher degree of integration.

The limited space for disposing such passive elements increases the complexity of package designs and increases the manufacturing costs. In particular, passive elements 260 in a dense package may limit heat dissipation paths, may increase design time with complex trace routing paths, and may increase the likelihood of errors in the manufacturing process.

That is, forming passive elements or passive circuits, such as resistors, capacitors, and inductors, on a semiconductor substrate may increase the complexity of the process and may result in additional costs.

### SUMMARY OF THE INVENTION

The present invention has been made in view of the above problems, and it is an object of the present invention to provide a fan-out package including a bridge structure that relieves the routing density of traces in a fan-out packaging process and improves electrical performance by the provision of a passive element and a method of manufacturing the same.

In accordance with one aspect of the present invention, the above and other objects can be accomplished by the provision of a fan-out package in which two or more dies are integrated, wherein the fan-out package includes a bridge structure including a bridge substrate formed on one side of the fan-out package, a redistribution layer formed on the bridge substrate, the redistribution layer including at least one trace, the redistribution layer being configured to electrically connect the dies to each other, and a passive element formed in the redistribution layer by patterning.

In accordance with another aspect of the present invention, there is provided a method of manufacturing a fan-out package, the method including forming a fan-out package in which two or more dies are integrated and locating a bridge structure on one side of the fan-out package, wherein the bridge structure includes a bridge substrate, a redistribution layer including at least one trace, the redistribution layer being configured to electrically connect the dies to each other, and a passive element formed in the redistribution layer, and the passive element is formed in the redistribution layer by thin film deposition and patterning through a patterning process on the bridge substrate.

The redistribution layer may be formed as one or more layers, and a passivation layer may be formed therebetween.

In addition, the redistribution layer may include a trace and a connection terminal formed at the end of the trace. In addition, a solder ball may be formed at the connection terminal, and the solder ball may be connected to a solder ball formed at the fan-out package.

In addition, the redistribution layer may be formed on one surface or both surfaces of the bridge substrate.

The passive element may be at least one of a resistor, a capacitor, and an inductor.

The resistor may be formed by forming a thin film resistive layer on the bridge substrate and patterning the thin film resistive layer in the redistribution layer through a patterning process. In addition, the resistor may be made of nichrome (NiCr) or tantalum nitride (TaN). In addition, the inductor may be formed by forming a thin metal layer on the bridge substrate and patterning the thin metal layer in a spiral shape.

In addition, the redistribution layer may be formed as one or more layers, and a passivation layer may be formed therebetween to form different passive circuits or to form a capacitor or a balun.

### BRIEF DESCRIPTION OF THE DRAWINGS

FIG. 1 is a schematic view of a conventional fan-out package;
FIG. 2 is a schematic view of a fan-out package including a bridge structure according to an embodiment of the present invention;
FIG. 3 is a coupled schematic view of the embodiment of FIG. 2;
FIG. 4 is a schematic view of a fan-out package including a bridge structure according to another embodiment of the present invention; and
FIGS. 5 and 6 are schematic views showing the state in which the fan-out package and the bridge structure according to the embodiment of the present invention are connected to each other via solder balls.

### DETAILED DESCRIPTION OF THE PREFERRED EMBODIMENTS

The present invention relates to a fan-out package including a bridge structure, wherein the bridge structure for auxiliary connection between dies (chips) is introduced in a fan-out packaging process, whereby the routing density of traces is relieved and the degree of freedom of trace design is improved, and a passive element is provided in a redistribution layer, whereby electrical performance is improved, and a method of manufacturing the same.

Hereinafter, embodiments of the present invention will be described in detail with reference to the accompanying drawings.

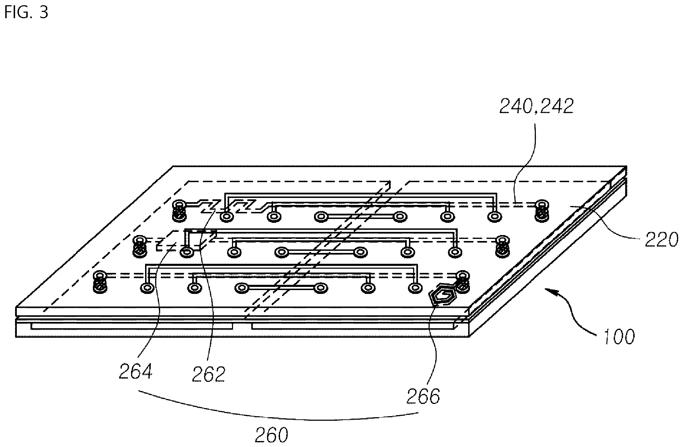

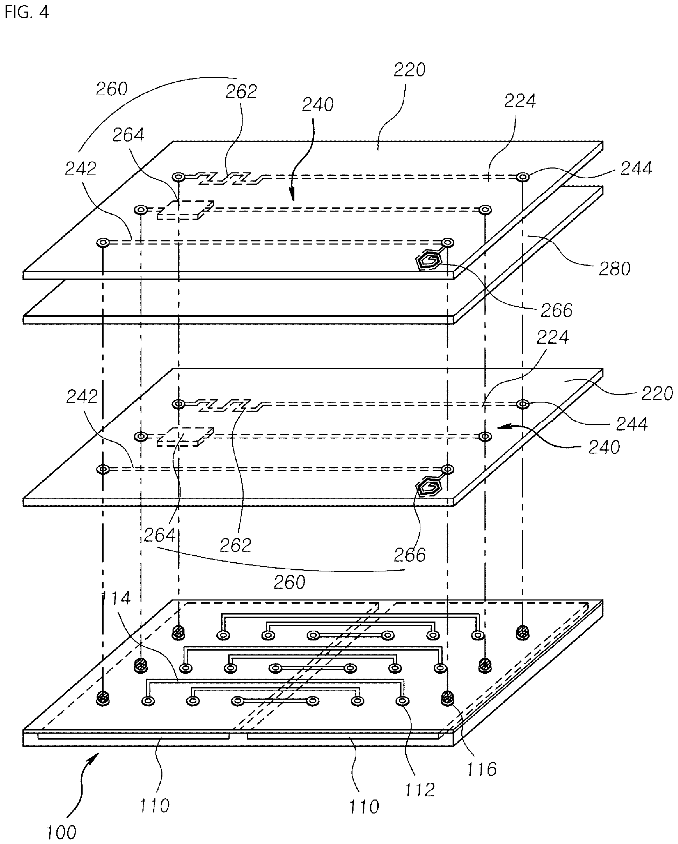

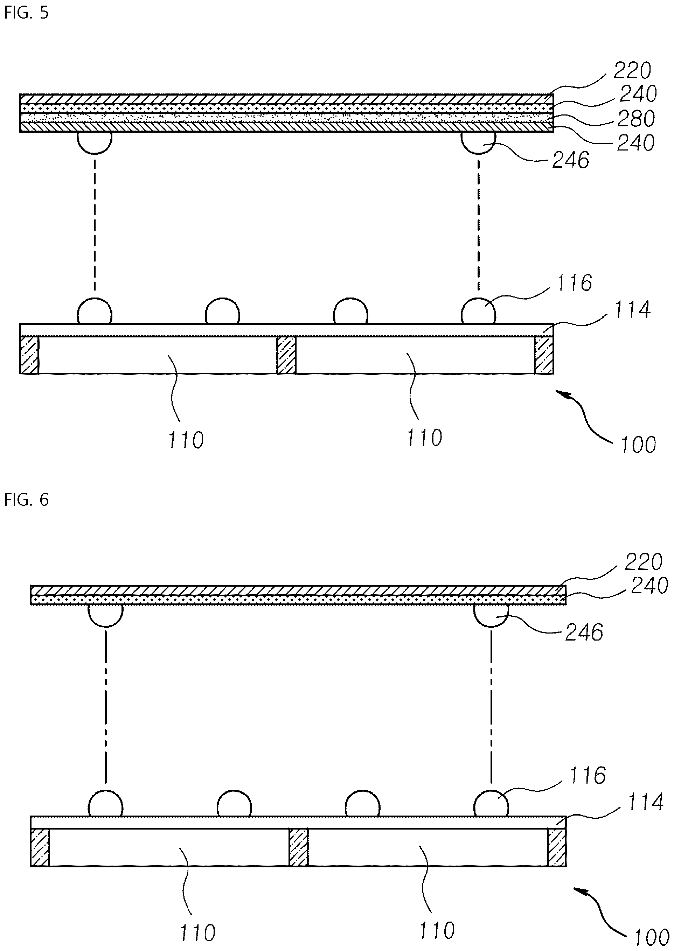

FIG. 2 is a schematic view of a fan-out package including a bridge structure according to an embodiment of the present invention, FIG. 3 is a coupled schematic view of the embodiment of FIG. 2, FIG. 4 is a schematic view of a fan-out package including a bridge structure according to another embodiment of the present invention, and FIGS. 5 and 6 are schematic views showing the state in which the fan-out package and the bridge structure according to the embodiment of the present invention are connected to each other via solder balls.

As shown, the fan-out package including the bridge structure according to the present invention, which is a fan-out package in which two or more dies 110 are integrated, includes a bridge substrate 220 formed on one side of the fan-out package 100, a redistribution layer 240 formed on the bridge substrate 220, the redistribution layer including at least one trace and being configured to electrically connect the dies 110 to each other, and a passive element 260 formed in the redistribution layer 240 by patterning.

In the present invention, therefore, the bridge structure for auxiliary connection between chips is introduced in a fan-out packaging process, whereby the routing density of traces may be relieved and the degree of freedom of trace design may be improved, and the passive element 260 is provided in the redistribution layer 240, whereby electrical performance may be improved.

In the present invention, a bridge substrate 220 formed on one side of a fan-out package 100 in which two or more dies 110 are integrated, a redistribution layer 240 including at least one trace 242 formed on the bridge substrate 220, the redistribution layer having a passive element 260 formed thereon by patterning, and a connection terminal 244 formed at the end of the trace 242, the connection terminal being in contact with contact a terminal 112 of the fan-out package 100 are included, whereby different dies 110 integrated in the fan-out package 100 are electrically connected to each other.

The fan-out package 100 according to the embodiment of the present invention, in which two or more dies (chips) 110 are integrated, may be implemented in various ways, such as a molded and embedded fan-out package 100 or a surface-mounted fan-out package 100.

In the present invention, the die 110 and the chip are generally the same conceptually, and may be selected and used appropriately for each part.

Meanwhile, generally, in the embedded fan-out package 100, a chip formed on a silicon wafer is diced, a chip determined to be normally operated is located on a carrier wafer by reconstitution, a chip redistribution layer (RDL) is formed on the chip and a fan-out area, a solder bump or a solder pad is formed, and dicing is performed on a per-chip or per-chiplet (module) basis.

The solder bump or the solder pad according to the redistribution layer forms an input/output terminal (I/O) of the fan-out package 100, and serves as a contact terminal 112 for connection between different modules or chips.

As electronic devices become more powerful and data throughput increases, the number of chips for data processing and the number of I/Os increases, fan-out packages become useful, and a highly integrated, multi-functional module or package is provided by integrating one or more chips.

As shown in FIG. 1, in the case of a conventional fan-out package having two or more dies embedded therein, even if I/Os are redistributed, the routing of the traces is limited due to the space limitations, and the connection between the die (chips) is not easy, and the design process requires a lot of effort and cost, and depending on the type of die, the density of the die increases, which increases the possibility of short circuits or signal transmission errors.

To this end, the present invention introduces a bridge structure for connection between chips to one side of the fan-out package 100, and the bridge substrate 220 according to the embodiment of the present invention is formed on one side of the fan-out package 100, preferably on the top of the chip or chip redistribution layer. That is, in the case of a package having a chip front structure, the bridge substrate may be formed on the lower side of the package, and in the case of a package having a chip back structure, the bridge substrate may be formed on the upper side of the package. As needed, the bridge substrate may be formed on the upper and lower sides of the package.

In addition, the bridge substrate 220 according to the embodiment of the present invention may be formed between chips, may be formed on the entire surface of the chip, or may be formed larger or smaller than the entire surface of the chip depending on the shape of the die 110, the disposition or position of the input and output terminal, etc.

The bridge substrate 220 according to the embodiment of the present invention may be made of an electrically insulating material, may use an electrochemically stable, easily processed material, and may be formed in various shapes depending on the shape of the dies 110 that are electrically connected to each other or the disposition of the input and output terminal.

Preferably, the bridge substrate 220 is formed in a thin rectangular plate shape, and a rigid material or a flexible material is used. For example, an inorganic material, an organic material, or an organic-inorganic composite material may be used.

In an embodiment of the present invention, any one of a silicon substrate, a polymer substrate, a ceramic substrate, an organic-inorganic composite material substrate, and a glass fiber impregnated substrate may be used as the bridge substrate 220.

In addition, the bridge substrate 220 may include a polymer resin on the substrate, wherein the polymer resin may include an epoxy-based insulating resin or a polyimide-based resin.

When the polymer resin is included, an epoxy-based insulating resin, such as FR-4, bismaleimide triazine (BT), or Ajinomoto build up film (ABF), may be included.

The bridge substrate 220 for auxiliary connection between chips may be packaged simultaneously in a die-molding packaging process as needed, and may be disposed at a predetermined position for connection between chips after die-molding is completed.

The redistribution layer 240, which includes at least one trace 242 and is configured to electrically connect the dies to each other, is formed on the bridge substrate 220 according to the present invention. The trace 242 may be formed in the shape of one or more wires in consideration of a signal transmission speed depending on the disposition of the contact terminal 112 of the chip to be connected.

In addition, the trace 242 may be formed in a plurality of columns or rows, and may be formed in a pattern of various shapes, such as a straight line, a curved line, a bent line, two or more branch lines, and various combinations thereof.

The trace 242 may be formed on the substrate by vacuum deposition, such as sputtering, and may be formed on one surface or both surfaces of the bridge substrate 220, or may be embedded (molded) in the substrate or may be surface-mounted on the substrate.

In addition, the redistribution layer 240 may be formed as one or more layers depending on the complexity of routing of the trace for chip connection, and a passivation layer 280 is formed therebetween (see FIG. 4). In addition, the redistribution layer 240 may be formed on one surface or both surfaces of the bridge substrate 220.

The passive element 260 according to the present invention is formed in the redistribution layer 240 by patterning.

The redistribution layer 240 is formed on the bridge substrate 220, e.g., a silicon bridge substrate 220 as an embodiment of the present invention, and the passive element 260 is formed on the redistribution layer 240.

That is, electrical performance may be improved by integrally forming passive elements 260, such as a resistor 262, a capacitor 264, and an inductor 266, in the redistribution layer 240 according to the present invention, and space-saving effects may be achieved by forming the passive elements 260 on the bridge structure in the fan-out package 100. As the result of forming the passive elements in the redistribution layer 240, signal integrity may be improved, parasitic elements may be reduced, and the distributed formation of the passive elements 260 in the bridge structure is effective for thermal management during operation of the elements.

The resistor 262 according to the embodiment of the present invention may be formed by forming a thin film resistive layer on the bridge substrate 220 and patterning the thin film resistive layer in the redistribution layer 240 through a patterning process. The resistor 262 may be made of nichrome (NiCr) or tantalum nitride (TaN), and may be formed by forming a thin film layer on the bridge substrate 220 through a sputtering process and patterning the thin film layer through a patterning process.

The inductor 266 according to the embodiment of the present invention may be formed by forming a thin metal layer on the bridge substrate 220 and patterning the thin metal layer in a spiral shape. The inductor is generally made of copper or aluminum, which exhibits good conductivity, and is formed in the redistribution layer 240 by patterning in a spiral or labyrinthine shape. The inductor 266 is suitable for RF applications and provides compact and efficient inductance.

The capacitor 264 according to the embodiment of the present invention has a structure of metal/insulator (passivation layer 280)/metal, and is formed by stacking a dielectric between metal layers. SiO₂ or Si₃N₄ may be used as a general dielectric.

Meanwhile, the redistribution layer 240 is formed as one or more layers, and the passivation layer 280 is formed therebetween to form different passive circuits or to form the capacitor 264 or a balun. That is, the bridge structure is a structure of metal/insulator (passivation layer 280)/metal, which naturally forms the capacitor 264.

In addition, it is possible to design a balun using a coupled inductor 266 and capacitor 264, which is optimized for signal matching and variation using the same materials and processes as the inductor 266 and capacitor 264.

That is, it is possible to provide excellent electrical performance in high-frequency and RF applications by integrating high-performance passive elements 260, such as the capacitor 264 having the metal-insulator-metal (MIM) structure and the spiral inductor 266, and it is possible to optimize overall system performance by reducing signal interference and crosstalk.

In addition, the metal layer of the substrate and the passive element 260 are protected through the passivation layer 280, whereby it is possible to protect the system from environmental stress and physical damage, to increase the durability of the semiconductor package, and to ensure long-term reliability.

The connection terminal 244 for connection with the contact terminal 112 of the fan-out package 100 may be formed at the end of the trace 242.

The contact terminal 112 of the fan-out package 100 is generally formed as a solder pad or a solder bump according to the chip redistribution layer (RDL) for connection between chips in a chip area and a fan-out area, and the solder bump or the solder pad may be an input and output terminal.

The chip redistribution layer may be formed by routing the trace 114 for the input/output terminal in the chip area or the fan-out area according to routing design of the trace 114 for connection between chips, and the end of the trace 114 may be finished with the solder bump or the solder pad.

The connection terminal 244 is electrically connected to the contact terminal 112 of the fan-out package 100, and a metal connection portion (e.g., a through silicon via (TSV)), a solder bump, and a solder bump pillar may be used alone or in combination in consideration of the shape of the contact terminal 112 of the fan-out package 100, the shape of the die 110 or the height of the chip and bridge substrate 220, and the contact distance to a packaging substrate or a silicon interposer.

Here, the connection terminal 244 may be formed on a via formed on the bridge substrate 220, or may be formed on a solder pad formed on the bridge substrate 220, depending on the mounting form of the trace 242.

In the embodiments of the present invention shown in FIGs. 2 to 4, traces 242 arranged at a constant pitch are formed on one side (top and/or bottom) of the bridge substrate 220, and connection terminals 244 are formed at both ends of each trace 242.

In the embodiment of FIGs. 2 and 3, for connection between chips, the bridge substrate 220 formed in a size almost equal to the entire surface of the package, and three rows of traces 242 are formed on the bridge substrate 220 in straight lines of equal size.

In the embodiment of FIG. 4, the redistribution layer 240 is formed in one or more layers, and the passivation layer 280 is formed therebetween.

According to each embodiment, the passive elements 260, such as the resistor 262, the capacitor 264, and the inductor 266, are formed in the redistribution layer 240, and in the case of FIG. 4, the passive elements are formed on each of the two redistribution layers 240. As a result, new passive circuits or new passive elements may be implemented, electrical performance may be further improved, and space-saving effects may be achieved by forming the passive elements 260 in a bridge structure in the fan-out package 100.

In the above embodiments, the contact terminals 112 on the outermost side are connected to the connection terminals 244 of the traces 242 formed on the bridge substrate 220 for connection between chips, whereby connection between all of the contact terminals 112 on the chip is achieved, and the traces are distributed on the bridge substrate 220, whereby the routing density of the traces is relieved.

In the embodiment of the present invention, the connection terminals 244 formed at both ends of the traces 242 may be implemented by vias formed on the bridge substrate 220 and solder pads formed on outer surfaces of the vias.

If the traces 242 are formed on the lower surface of the bridge substrate 220, the vias may not be formed, and each of the connection terminals 244 may be implemented as a combination of a solder pad and a solder bump, and a via and a metal connection portion may be formed to increase utilization.

The structure of the connection terminal 244 is designed in consideration of the shape of the contact terminal 112 of the fan-out package 100, the shape of the die 110 or the height of the chip and bridge substrate 220, and the contact distance to the packaging substrate or the silicon interposer S, as described above.

The trace 242 and the connection terminal 244 may be made of a conductive metal such as copper, and the trace 242 and the connection terminal 244 may be manufactured simultaneously or sequentially. That is, the trace 242 may be formed after the connection terminal 244 is formed, or the trace 242 may be formed after the connection terminal 244 is formed, depending on the design of the bridge substrate 220.

In addition, the connection terminal 244 may be located outside or inside the die 110 in the fan-out package 100. When the connection terminal 244 is located outside die 110, the routing density of the traces 242 may be further relieved. This is designed appropriately taking into account the type of chip and the signal transmission distance.

The routing design of the traces formed on the bridge substrate 220 may be achieved in various shapes in response to the disposition, shape, number, etc. of the traces 114 for direct connection between the chip and the contact terminals (or input and output terminals) 112 of the chip or the package.

In addition, as described above, the traces 242 may be formed on one surface or both surfaces of the bridge substrate 220 or in the bridge substrate 220 by molding, thereby providing a high degree of freedom of trace design.

In addition, as shown in FIGs. 5 and 6, the bridge structure is in contact with the fan-out package via solder balls 116 and 246, solder pads, or solder bumps.

For example, when the solder balls 116 and 246 formed on the bridge structure and the fan-out package 100 are in contact with each other, the solder ball 246 of the bridge structure and the solder ball 116 of the fan-out package 100 corresponding thereto are electrically connected to each other via the redistribution layer (trace) 240 of the bridge structure. This relieves the density of traces in the fan-out package 100, which may reduce short circuits and minimize signal transmission errors.

FIG. 5 shows that the redistribution layer 240 is formed as one or more layers and the passivation layer 280 formed therebetween. Specifically, two redistribution layers 240 are formed on the bridge substrate and the passivation layer 280 formed therebetween, wherein solder balls 246 are formed on the connection terminals of the lower redistribution layer 240 to provide a bridge structure. The bridge structure is coupled to the fan-out package 100, whereby the solder balls 246 of the redistribution layer 240 and the solder balls 116 formed on the fan-out package 100 are in contact with each other and electrically connected to each other. FIG. 6 shows that the redistribution layer 240 is implemented as a single layer.

In the present invention, as described above, when connection between chips is difficult or the routing density of traces is too high due to the function or shape of a chip or a large number of I/Os in fan-out packaging, a bridge structure for connection between chips is introduced such that a part of the routing is distributed to the bridge structure, whereby it is possible to improve the degree of freedom of trace routing design and to improve production efficiency.

In addition, integrally forming passive elements such as a resistor, a capacitor, and an inductor in a redistribution layer (RDL) according to the present invention may improve electrical performance, and in a fan-out package, the passive elements are formed in the bridge structure, whereby space-saving effects may be achieved. As the result of forming the passive elements in the redistribution layer, signal integrity may be improved, parasitic elements may be reduced, and thermal management during operation of the elements is effective because the passive elements are formed in the bridge structure in a distributed state.

As is apparent from the above description, the present invention provides a fan-out package including a bridge structure, wherein the bridge structure for auxiliary connection between chips is introduced in a fan-out packaging process, whereby the routing density of traces is relieved and the degree of freedom of trace design is improved, and a passive element is provided in a redistribution layer, whereby electrical performance is improved.

In addition, passive elements, such as a resistor, a capacitor, and an inductor, are directly integrally formed in the redistribution layer on a bridge substrate to effectively reduce parasitic resistance, parasitic inductance, and parasitic capacitance, whereby it is possible to improve signal integrity and to minimize performance degradation in high frequency and high speed signal processing applications.

In addition, the passive elements according to the present invention are integrated into the redistribution layer 240 of the bridge structure by patterning, whereby the space in the package is reduced and a semiconductor apparatus is miniaturized. This also enables realization of highly integrated packaging.

Furthermore, the bridge structure according to the present invention enables excellent heat dissipation through high thermal conductivity and mechanical stability, thereby solving the thermal management problem of a high-performance semiconductor apparatus, and increasing the reliability and lifespan of the apparatus by optimizing a heat dissipation path.

## Claims

1. A fan-out package in which two or more dies are integrated, wherein the fan-out package comprises a bridge structure comprising:
a bridge substrate formed on one side of the fan-out package;
a redistribution layer formed on the bridge substrate, the redistribution layer comprising at least one trace, the redistribution layer being configured to electrically connect the dies to each other; and
a passive element formed in the redistribution layer by patterning.

2. The fan-out package according to claim 1, wherein the redistribution layer is formed as one or more layers, and a passivation layer is formed therebetween.

3. The fan-out package according to claim 1, wherein the redistribution layer comprises a trace and a connection terminal formed at an end of the trace.

4. The fan-out package according to claim 3, wherein a solder ball is formed at the connection terminal, and the solder ball is connected to a solder ball formed at the fan-out package.

5. The fan-out package according to claim 1, wherein the redistribution layer is formed on one surface or both surfaces of the bridge substrate.

6. The fan-out package according to claim 1, wherein the passive element comprises at least one of a resistor, a capacitor, and an inductor.

7. The fan-out package according to claim 6, wherein the resistor is formed by forming a thin film resistive layer on the bridge substrate and patterning the thin film resistive layer in the redistribution layer through a patterning process.

8. The fan-out package according to claim 7, wherein the resistor is made of nichrome (NiCr) or tantalum nitride (TaN) .

9. The fan-out package according to claim 6, wherein the inductor is formed by forming a thin metal layer on the bridge substrate and patterning the thin metal layer in a spiral shape.

10. The fan-out package according to claim 1, wherein the redistribution layer is formed as one or more layers, and a passivation layer is formed therebetween to form different passive circuits or to form a capacitor or a balun.

11. A method of manufacturing a fan-out package, the method comprising:
forming a fan-out package in which two or more dies are integrated; and
locating a bridge structure on one side of the fan-out package, wherein
the bridge structure comprises a bridge substrate, a redistribution layer comprising at least one trace, the redistribution layer being configured to electrically connect the dies to each other, and a passive element formed in the redistribution layer, and
the passive element is formed in the redistribution layer by thin film deposition and patterning through a patterning process on the bridge substrate.

12. The method according to claim 11, wherein one or more redistribution layers are formed on the bridge substrate, and a passivation layer is formed between the respective redistribution layers.

13. The method according to claim 11, wherein the redistribution layer comprises a trace and a connection terminal formed at an end of the trace.

14. The method according to claim 13, wherein a solder ball is formed at the connection terminal, and the solder ball is connected to a solder ball formed at the fan-out package.

15. The method according to claim 11, wherein the redistribution layer is formed on one surface or both surfaces of the bridge substrate.
